# EUROPEAN PATENT SPECIFICATION

(11) **EP 1 089 851 B1**
(45) Date of publication and mention of the grant of the patent: **16.10.2002**
(21) Application number: 99926637.2
(22) Date of filing: 17.06.1999
(51) Int. Cl.: B24B 9/06, B24B 7/22, B24B 37/04, B24B 49/16, B24B 51/00, B24B 53/00, B24B 55/04

(54) **WAFER EDGE POLISHING METHOD AND APPARATUS**
VERFAHREN UND VORRICHTUNG ZUM ABFASEN VON HALBLEITERSCHEIBEN
PROCEDE ET DISPOSITIF DE POLISSAGE DE BORDS DE PLAQUETTE

(30) Priority: 25.06.1998 GB 9813606; 12.05.1999 GB 9910898
(43) Date of publication of application: 11.04.2001
(73) Proprietor: Unova U.K. Limited, Aylesbury, Buckinghamshire HP20 2RQ (GB)
(72) Inventor: STOCKER, Mark, Andrew, East Hunsbury Northampton NN4 OPO (GB)
(74) Representative: Nash, Keith Wilfrid
(86) International application number: PCT/GB99/01928
(87) International publication number: WO 99/067054

(56) References cited:
- EP-A- 0 549 143
- EP-A- 0 552 989
- EP-A- 0 601 748
- EP-A- 0 764 976

## Description

### Field of invention

This invention concerns the polishing of the edges of semi-conductor wafers such as silicon wafers and apparatus therefor.

### Background to the invention

Reference is made here to EP-A-0 549 143 which discloses an apparatus for wafer edge polishing in which there is provided means for rotating a wafer, a polishing wheel having a groove therein for accomodating the peripheral rim of the wafer, means for rotating the wheel, drive means for effecting relative movement between the wheel and the wafer to effect engagement of the wafer in the groove.

Further, reference is made to EP-A-0 764 976 which discloses a method of edge grinding and polishing semi-conductor wafers which are transported in turn to a grinding station in which the edge of the wafer is ground, and the wafer is then transferred to a buffer store whilst the next wafer is conveyed to and located in the grinding station for grinding, which further comprises the steps of rotating the wafer in the buffer store and engaging the edge thereof with a polishing wheel, to polish its periphery whilst the next wafer is being ground, and after polishing, the polished wafer is removed and the next wafer is transferred from the grinding station to the buffer store for polishing to allow a further wafer to be located in the grinding station.

When silicon has been crystallised into large boules, which are generally cylindrical over most of their length, the crystalline material is sliced into thin circular discs known as silicon wafers, the diameter of each of which can be anything within the range 25 - 300mm. After mounting in a vacuum chuck in an edge grinding machine, the peripheral edges of the discs are accurately ground so as to produce an accurate circular shape centered on the centre of the disc and a precisely formed edge profile, and are often notched at one position around the circular periphery.

Whereas over the majority of the area of disc the thickness is uniform and the two faces are parallel, the periphery of such discs are ground to a triangular section in which the apex of the triangle defines the outermost diameter of the wafer and is normally located midway between the two parallel faces of the disc.

In order to optimise the manufacture of semi-conductor devices using such a disc, it is important that the surface which is to be exposed to photo-lithography is damage free and in view of the microscopic size of the microcircuits which are formed on the wafers, damage near to the circumferential line between which the flat circular surface merges with the inclined surface leading to the apex, can significantly reduce the number of devices which can be made from the wafer.

In machines which do not produce a good quality ground finish to the inclined surfaces of the triangular section leading to the apex, it is necessary to etch and then polish the edges of the wafer before it can be used in the construction of semi-conductor devices. Where a good quality ground finish is produced on the inclined surfaces leading to the apex, it is only necessary to etch and polish a small quantity of material in order to obtain an undamaged edge.

It is an object of the present invention to provide an improved method and apparatus for polishing a finely ground wafer edge.

### Summary of the invention

The invention lies in apparatus for wafer edge polishing in which there is provided means for rotating a wafer, a polishing wheel having a groove therein for accommodating the peripheral rim of the wafer, means for rotating the wheel, drive means for effecting relative movement between the wheel and the wafer to effect engagement of the wafer in the groove, and further drive means to effect relative rocking movement between the wafer and the wheel such that opposite faces of the peripheral rim of the wafer are engaged alternately by opposite regions of the surface of the groove in the wheel during the polishing process.

Preferably, a jet orifice is located near to the region of engagement between the wafer and the wheel, for directing a fluid slurry towards the region of engagement at least during the polishing process.

According to another prefered feature, a groove-forming wheel (a grooving tool) is mounted for engagement with the groove in the polishing wheel either by movement of the grooving tool towards the wheel or the wheel towards the tool, and for mutually rotating both wheel and tool so as to form or reform the groove in the surface of the wheel.

Where the grooving tool is a disc, the latter may be mounted to the rear of the wafer support for rotation therewith, and the forming step is performed by moving the grooved wheel into engagement with the grooving tool and rotating both so as to form or reform the groove in the wheel.

The polishing wheel may have a significant axial depth, and two or more parallel grooves are formed therearound, so that as one groove becomes worn and needs reforming, the wheel can be indexed so as to use another of the grooves for polishing the edge of the wafer and the process of moving from one groove to another can be continued until all of the grooves have been utilised and need reforming before the process is arrested and a reforming process is performed on the polishing wheel grooves.

Typically the polishing wheel is rotated contra to the direction of rotation of the workpiece in the zone of contact.

Typically the synthetics plastics material is polyurethane.

Typically the polishing slurry is colloidal silica.

Whereas with edge grinding, the grooved grinding wheel is advanced during the grinding process with a controlled feed rate, it has been found more preferable to advance a synthetic plastics polishing wheel in such a manner as to engage the edge of the workpiece in a so-called plunge mode and under constant force.

A polished surface has been obtained in a matter of a few minutes, typically of the order of 2 to 4 minutes.

According to another aspect of the invention, there is provided the method defined in claim 8. The method may be performed as a modified edge grinding machine which whereby permits the disc to be edge ground and then polished while still mounted on the same chuck, by withdrawing the grinding wheel and advancing the polishing wheel and thereafter performing the aforesaid method. A washing step may be included between the grinding step an the polishing step.

Preferably the method is under the control of a computer programmed to instigate the different steps of the process.

The invention will now be described, by way of example, with reference to the accompanying drawings in which:
Figure 1 is a diagrammatic elevation of a polishing wash station for use in combination with a wafer edge grinding apparatus;
Figure 2 is a diagrammatic top plan view of apparatus such as shown in Figure 1; and
Figure 3 is a diagrammatic view in elevation, showing a modified mechanism for causing the polishing wheel to execute an oscillating motion.

The invention is applicable to the polishing of semi-conductor wafers which have been edge ground by an edge grinder such as described in UK Patent Specification No. 2317585.

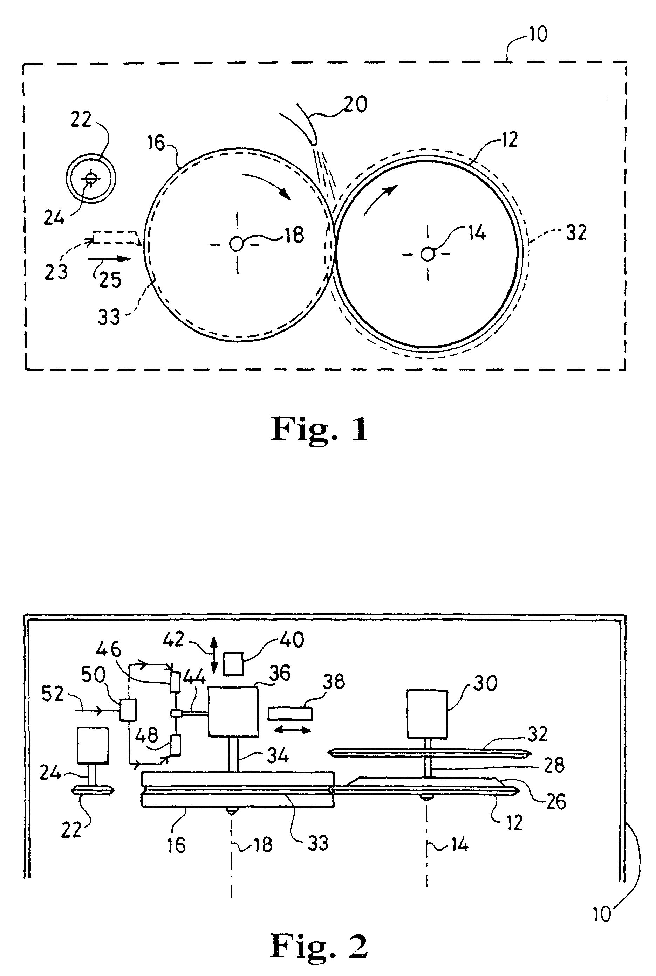

The apparatus illustrated diagrammatically in Figure 1 comprises a housing 10 within which is located a wafer 12 mounted on a vacuum chuck adapted for rotation about an axis 14, and a urethane polishing wheel 16 mounted for rotation about parallel axis 18.

A shallow V-shaped groove 33 is formed around the periphery of the polishing wheel 16. The wheel and the wafer are rotated as relative movement brings the two into engagement, so that the triangular section periphery of the wafer enters the groove 33 around the wheel. Both the wheel and the wafer are rotated clockwise, as shown by the arrows, so that there is contrary motion at the point of engagement.

A jet 20 projects a fluid polishing slurry downwards in the direction of motion of the peripheral region of the wheel 16 which will engage the wafer 12. The slurry may typically be an alkali solution of pH11 with colloidal silica having a mean particle size of 30-50nm: for example a slurry known as Klubesol 50R50 manufactured by the company Clariant and diluted 10:1 with water.

Remote from the wafer is located a groove-forming wheel 22 rotatable about an axis 24. Relative movement between forming wheel 22 and polishing wheel 16 brings the edge of the wheel 22 into contact with the wheel 16 and into the groove 33 around the wheel. The peripheral shape of the forming wheel 22 is similar to the peripheral cross-sectional shape of the wafers such as 12 which are to be polished by the groove in the polishing wheel 16, and by forming the wheel 22 from a hard material and the polishing wheel 16 from a compliant material such as urethane, the groove 33 around the wheel will be formed or re-formed due to the engagement between the forming wheel and the groove in the polishing wheel.

As an alternative to the forming wheel 22, there may be provided a non-rotatable profiled turning tool 23, (shown in chain-dotted outline), which in operation is slidable in the direction of arrow 25 into engagement with the wheel 16 for forming or re-forming the groove 33.

Figure 2 shows the apparatus of Figure 1 in more detail and from above.

The wafer 12 is shown mounted on a vacuum chuck 26 carried by a spindle 28 driven in rotation by a motor 30. Optionally mounted on the shaft 28 (in place of wheel 22) is a groove-forming wheel 32 having a profiled periphery adapted to form the V-shaped groove 33 in the cylindrical face of the polishing wheel 16.

Polishing wheel 16 is carried by a shaft 34 driven in rotation by a motor 36.

The motor 36 is mounted on a slideway and is laterally slidable therealong under the action of an air cylinder 38 so as to effect engagement of the wafer 12 with the groove 33 or by appropriate axial movement by means of another drive 40, in the direction of the arrow 42, to effect engagement between the groove 33 and the groove-forming wheel 32.

The motor 36 is mounted for pivotal motion about a generally vertical axis relative to its slideways, and a lever 44 is shown extending from one side of the motor housing acted on by two piston and cylinder drive arrangements 46 and 48 which are selectively supplied with fluid such as air via a valve 50 from an air line 52.

By alternately supplying fluid to one and then the other of the drives 46, 48, so the pistons are driven in first one direction and then the other. This oscillates the lever 44, and therefore the motor attached thereto, so as to produce a rocking motion about the axis of pivoting.

Ideally the polishing wheel and drive assembly is carried by upper and lower pivoting arms which transfer the pivoting motion to an axis which extends substantially through the centre of the polishing wheel in a generally vertical sense.

To this end the motor housing may be mounted between upper and lower arms which protrude therefrom in a forward sense above and below the polishing wheel 16 and vertically aligned pivot bearings are provided above and below the wheel to which the arms are attached and about which the arm assembly can swivel to effect the rocking motion of the wheel 16 relative to the wafer 12, about the vertical axis.

The rocking motion polishes the flanks of the triangular cross-sectional edge region of the wafer 12.

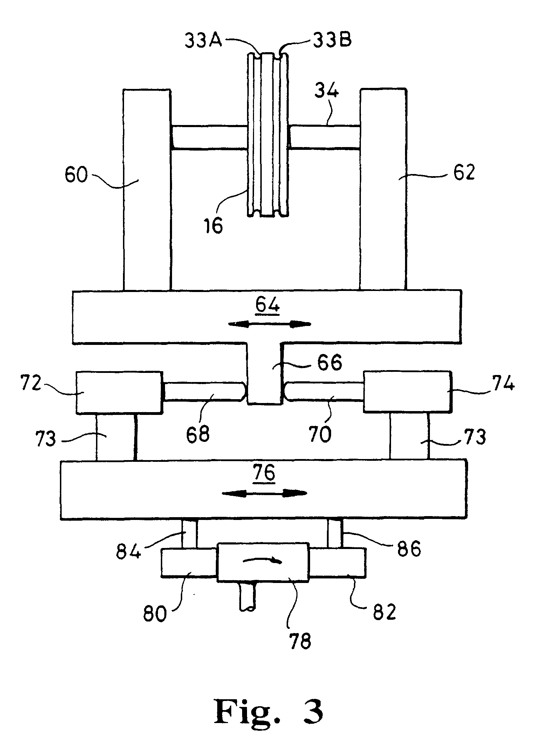

Figure 3 shows in elevation a modified arrangement for causing the polishing wheel 16 to execute an oscillating motion relative to the wafer (not shown). The wheel is provided with two grooves 33 A and 33 B so that when one becomes worn the other can be utilised.

Here the wheel 16 is mounted on shaft 34 and supported by trunnions 60, 62 on a slideway 64 which is mounted horizontally parallel to the rotational axis of the wafer. The shaft 34 is again driven in rotation by a motor (not shown).

Projecting downwards from the slideway 64 is a spigot 66 whose opposite sides are engaged alternatively by push rods 68, 70 of respective air cylinders 72, 74, which in turn are mounted via supports 73 on a slidable plate 76. Horizontal movement of the plate, and hence of the cylinders, is controlled by a motor driven cam 78, such as an eccentric, engagable with rotatable cam followers 80, 82 whose spindles 84, 86 are connected to the plate 76.

In operation, rotation of the cam 78 causes spigot 66 to be engaged alternately by the two rods 68, 70. The air pressure P in the cylinders is regulated such that the lateral force exerted on the wafer flanks is constant, regardless of the actual displacement of the cylinder rods.

## Claims

1. Apparatus for wafer edge polishing in which there is provided means for rotating a wafer (12), a polishing wheel (16) having a groove (33) therein for accommodating the peripheral rim of the wafer, means (36) for rotating the wheel, drive means (38) for effecting relative movement between the wheel and the wafer to effect engagement of the wafer in the groove, and further drive means (46,48) to effect a continuous rocking movement between the wafer the the wheel such that opposite faces of the peripheral rim of the wafer are engaged alternately by opposite regions of the surface of the groove in the wheel during the polishing process.

2. Apparatus according to claim 1 in which a jet orifice (20) is located near to the region of engagement between the wafer and the wheel, for directing a fluid slurry towards the region of engagement at least during the polishing process.

3. Apparatus according to claim 1 or claim 2 in which a grooving tool (22,23), for example a groove-forming wheel (22), is mounted for engagement with the groove in the polishing wheel either by movement of the grooving tool towards the wheel or the wheel towards the tool, and means for mutually rotating both wheel and tool so as to form or reform the groove in the surface of the wheel.

4. Apparatus according to claim 3 in which the grooving tool is a disc (32), mounted to the rear of the wafer support for rotation therewith, and the forming step is performed by moving the grooved wheel (16) into engagement with the grooving tool and rotating both so as to form or reform the groove in the wheel.

5. Apparatus according to any one of claims 1 to 4 in which the polishing wheel has a significant axial depth, and two or more parallel grooves are formed therearound, so that as one groove becomes worn and needs reforming, the wheel can be indexed so as to use another of the grooves for polishing the edge of the wafer and the process of moving from one groove to another can be continued until all of the grooves have been utilised and need reforming before the process is arrested and a reforming process is performed on the polishing wheel grooves.

6. Apparatus according to any one of claims 1 to 5 comprising a vacuum chuck for receiving and supporting the wafer, drive means for rotating the chuck and therefore the wafer about its centre, means for mounting a grooved polishing wheel for rotation about its central axis so that its direction of rotation is contra that of the rotation of the wafer in the region in which they will make contact, drive means for advancing and retracting the polishing wheel mounting means to enable the polishing wheel to make contact with the edge of the wafer for polishing purposes, and means for causing relative adjustment between the polishing wheel and the mounting means to ensure that the groove in the surface of the polishing wheel accurately aligns with the edge of the wafer.

7. Apparatus according to any one of claims 1 to 6 in which said further drive means is produced by at least one air cylinder, the pressure to which is regulated so that the force on the opposite faces of the wafer is constant regardless of the displacement of the cylinder.

8. A method of edge grinding and polishing semi-conductor wafers which are transported in turn to a grinding station in which the edge of the wafer is ground, and the wafer is then transferred to a buffer store whilst the next wafer is conveyed to and located in the grinding station for grinding, which further comprises the steps of rotating the wafer in the buffer store and engaging the edge thereof with a polishing wheel, to polish its periphery whilst the next wafer is being ground, and after polishing, the polished wafer is removed and the next wafer is transferred from the grinding station to the buffer store for polishing to allow a further wafer to be located in the grinding station, wherein the polishing step is effected by a rocking movement between the polishing wheel and the wafer edge by rocking either the wheel or the wafer about an axis, coincident with or parallel to a tangent which intersects the point of contact between the wafer and the polishing wheel.

9. A method according to claim 8 in which the wafers awaiting grinding are contained in a first store and the ground and polished wafers are contained in a second store.

10. A method according to claim 9 in which the first and second stores are different sections of a single storage device.

11. A method according to any one of claims 8 to 10 in which the buffer store comprises a wash station and further comprising the step of washing the ground wafer before the polishing step.

12. A method according to any one of claims 8 to 10 in which the wafer is washed after it has been polished.

13. A method according to any one of claims 8 to 12, further including the step of forming and reforming a groove in the polishing wheel after one or more polishing steps have been performed.

14. A method according to claim 13 in which the forming and reforming of the groove in the polishing wheel is effected by means of a groove-forming wheel having a triangular cross-section peripheral rim, defining in cross-section two slanting frusto-conical edges which converge in an apex, and after polishing one or more wafers, relative movement is effected between the groove-forming wheel and the polishing wheel whilst both are rotating about their respective axes, thereby to form or reform the cross-sectional shape of the groove in the polishing wheel ready for polishing the edges of further wafers.

15. A method according to any one of claims 8 to 14 further comprising the step of projecting a fluid slurry towards the point of engagement between the grooved polishing wheel and the periphery of the wafer at least during polishing engagement therebetween.

16. A method according to any one of claims 8 to 15 in which a grooving tool, for example a groove-forming wheel, is located in proximity to the grooved polishing wheel for engagement therewith to form and reforn the groove in the wheel as required.

17. A method according to any one of claims 8 to 16 in which the polishing wheel is made of synthetic plastics material and is brought into contact with the rotating edge of the wafer, said wheel having previously been formed around its polishing surface with a groove the cross-section of which is the complement of the edge profile of the wafer, a polishing slurry is supplied to the zone of contact between the polishing wheel and the edge of the wafer, and the polishing wheel is rotated so that relative movement exists between the polishing wheel and the said edge.

## Patentansprüche

1. Einrichtung zum Polieren von Kanten von Wafern, mit einer Vorrichtung zum Drehen eines Wafers (12), einer Polierscheibe (16) mit einer darin angebrachten Nut (33) zur Aufnahme des Umfangsrandes des Wafers, einer Vorrichtung (36) zum Drehen der Polierscheibe, einer Antriebsvorrichtung (38) zur Erzielung einer Relativbewegung zwischen der Polierscheibe und dem Wafer, um einen Eingriff des Wafers in der Nut zu erzielen, und einer weiteren Antriebsvorrichtung (46, 48) zur Erzielung einer kontinuierlichen hin- und hergehenden Bewegung zwischen dem Wafer und der Polierscheibe, derart, dass entgegengesetzte Stirnseiten des Umfangsrandes des Wafers abwechselnd durch gegenüberliegende Bereiche der Oberfläche der Nut in der Polierscheibe während des Poliervorganges in Eingriff gebracht werden.

2. Einrichtung nach Anspruch 1, bei der eine Strahlmündung (20) in der Nähe des Bereiches des Eingriffs zwischen dem Wafer und der Polierscheibe angeordnet ist, um einen Flüssigschlamm an den Bereich des Eingriffs mindestens während des Poliervorganges zu richten.

3. Einrichtung nach Anspruch 1 oder 2, bei der ein Nutformungs-Werkzeug (22, 23), z.B. eine Nutformungs-Scheibe (22) für den Eingriff mit der Nut in der Polierscheibe entweder durch Bewegen des Nutformungs-Werkzeuges auf die Scheibe zu oder der Scheibe auf das Werkzeug zu befestigt ist und eine Vorrichtung zum abwechselnden Drehen sowohl der Scheibe als auch des Werkzeuges vorgesehen ist, um eine Nut in der Oberfläche der Scheibe auszubilden oder nachzubessern.

4. Einrichtung nach Anspruch 3, bei der das Nutformungs-Werkzeug eine Scheibe (32) ist, die auf der Rückseite der Wafer-Abstützung zur Drehung damit befestigt ist, und der Formschritt durch Verschieben der genuteten Polierscheibe (16) in Eingriff mit dem Nutformungs-Werkzeug und durch Drehen beider durchgeführt wird, so dass die Nut in der Polierscheibe geformt oder nachgebessert wird.

5. Einrichtung nach einem der Ansprüche 1 - 4, bei der die Polierscheibe eine erhebliche axiale Tiefe hat und zwei oder mehr parallele Nuten darum herum ausgebildet sind, damit dann, wenn eine Nut Verschleißerscheinungen aufweist und eine Nachbesserung erforderlich wird, die Polierscheibe schrittweise weitergeschaltet werden kann, so dass eine andere der Nuten zum Polieren der Kante des Wafers benutzt und der Vorgang des Verschiebens von einer Nut zu einer anderen fortgesetzt werden kann, bis alle Nuten benutzt worden sind und eine Nachbesserung benötigen, bevor der Vorgang abgebrochen wird, und ein Nachbesserungs-vorgang an den Nuten der Polierscheibe durchgeführt wird.

6. Einrichtung nach einem der Ansprüche 1 - 5, mit einer Vakuum-Spannvorrichtung zum Aufnehmen und Abstützen des Wafers, einer Antriebsvorrichtung zum Drehen der Spannvorrichtung und damit des Wafers um seinen Mittelpunkt, einer Vorrichtung zum Befestigen einer genuteten Polierscheibe zur Drehung um die zentrische Achse, so dass die Drehrichtung entgegengesetzt zu der Drehrichtung des Wafers in dem Bereich, in dem eine Kontaktgabe erfolgt, verläuft, einer Antriebsvorrichtung zum Vorschieben und Zurückziehen der Polierscheiben-Befestigungsvorrichtung, damit die Polierscheibe Kontakt mit der Kante des Wafers zu Polierzwecken haben kann, und einer Vorrichtung, die einer relative Einstellung zwischen der Polierscheibe und der Befestigungsvorrichtung vornimmt, um sicher zu stellen, dass die Nut in der Oberfläche der Polierscheibe exakt mit der Kante des Wafers ausgerichtet ist.

7. Einrichtung nach einem der Ansprüche 1 - 6, bei der die weitere Antriebsvorrichtung durch mindestens einen Luftzylinder dargestellt ist, wobei der an den Zylinder angelegte Druck so geregelt wird, dass die Kraft auf die entgegengesetzten Stirnseiten des Wafers unabhängig von der Verschiebung des Zylinders konstant bleibt.

8. Verfahren zum Kantenschleifen und Polieren von Halbleiter-Wafern, die der Reihe nach an eine Schleifstation transportiert werden, in der die Kante des Wafers geschliffen wird, und der Wafer dann an einen Pufferspeicher übertragen wird, während der nächste Wafer in die Schleifstation transportiert und dort zum Durchführen des Schleifvorganges positioniert wird, **dadurch gekennzeichnet, dass** der Wafer im Pufferspeicher in Drehung versetzt und die Kante des Wafers mit einer Polierscheibe in Eingriff gebracht wird, um den Umfang des Wafers zu polieren, während der nächste Wafer geschliffen wird, und dass nach dem Polieren der polierte Wafer entfernt und der nächste Wafer von der Schleifstation an den Pufferspeicher zum Polieren übertragen wird, damit ein weiterer Wafer in der Schleifstation angeordnet werden kann, wobei der Polierschritt durch eine hin- und hergehende Bewegung zwischen der Polierscheibe und der Waferkante dadurch erzielt wird, dass entweder die Polierscheibe oder der Wafer um eine Achse hin- und herbewegt wird, die mit oder parallel zu einer Tangente zusammenfällt, die die Kontaktstelle zwischen dem Wafer und der Polierscheibe schneidet.

9. Verfahren nach Anspruch 8, bei dem die Wafer, die auf einen Schleifvorgang warten, in einem ersten Speicher, und die geschliffenen und polierten Wafer in einem zweiten Speicher gesammelt werden.

10. Verfahren nach Anspruch 9, bei dem die ersten und zweiten Speicher unterschiedliche Abschnitte einer einzigen Speichervorrichtung sind.

11. Verfahren nach einem der Ansprüche 8 - 10, bei dem der Pufferspeicher eine Waschstation aufweist, und der geschliffene Wafer vor dem Poliervorgang gewaschen wird.

12. Verfahren nach einem der Ansprüche 8 - 10, bei dem der Wafer nach dem Polieren gewaschen wird.

13. Verfahren nach einem der Ansprüche 8 - 12, bei dem der Schritt des Formens und Nachformens einer Nut in der Polierscheibe nach der Durchführung eines oder mehrerer Polierschritte vorgenommen wird.

14. Verfahren nach Anspruch 13, bei dem das Formen und Nachformen der Nut in der Polierscheibe mit Hilfe einer Nutformungs-Schleifscheibe mit einem Umfangsrand mit dreieckigem Querschnitt vorgenommen wird, der im Schnitt zwei geneigte, kegelstumpfförmige Kanten festlegt, die in einem Scheitelpunkt konvergieren, und nach dem Polieren eines oder mehrerer Wafer eine Relativbewegung zwischen der Nutformungs-Schleifscheibe und der Polierscheibe durchgeführte wird, während beide um ihre entsprechenden Achsen gedreht werden, wodurch die Querschnittsform der Nut in der Polierscheibe geformt oder nachgeformt wird, damit sie zum Polieren der Kanten von weiteren Wafern bereit ist.

15. Verfahren nach einem der Ansprüche 8 - 14, bei dem ein Flüssigschlamm an die Eingriffsstelle zwischen der genuteten Polierscheibe und dem Umfang des Wafers zumindest während des Poliereingriffes dazwischen gerichtet wird.

16. Verfahren nach einem der Ansprüche 8 - 15, bei dem ein Nutformungs-Werkzeug, beispielsweise eine Nutformungs-Scheibe in unmittelbarer Nähe der genuteten Polierscheibe zum Eingriff damit angeordnet ist, um die Nut in der Scheibe in der erforderlichen Weise zu formen und nachzuformen.

17. Verfahren nach einem der Ansprüche 8 - 16, bei dem die Polierscheibe aus synthetischem Kunststoffmaterial hergestellt und in Kontakt mit der rotierenden Kante des Wafers gebracht wird, wobei in der Polierscheibe vorher um ihre Polierfläche herum eine Nut ausgebildet worden ist, deren Querschnitt das Komplement des Kantenprofils des Wafers ist, ein Polierschlamm auf die Kontaktzone zwischen der Policrscheibe und der Kante des Wafers aufgebracht wird, und die Polierscheibe so in Drehung versetzt wird, dass eine Relativbewegung zwischen der Polierscheibe und dieser Kante auftritt.

## Revendications

1. Appareil pour polir des bords de tranches, dans lequel il est prévu un moyen pour faire tourner une tranche (12), un disque de polissage (16) présentant une rainure (33) pour y recevoir le rebord périphérique de la tranche, un moyen (36) pour faire tourner le disque, un moyen d'entraînement (38) pour effectuer un mouvement relatif entre le disque et la tranche afin d'assurer l'engagement de la tranche dans la rainure, et d'autres moyens d'entraînement (46, 48) pour effectuer un mouvement basculant continu entre la tranche et le disque de telle sorte que les faces opposées du rebord périphérique de la tranche soient engagées en alternance sur des régions opposées de la surface de la rainure ménagées dans le disque au cours du processus de polissage.

2. Appareil selon la revendication 1, dans lequel un orifice d'éjection (20) est situé à proximité de la région d'engagement entre la tranche et le disque pour diriger une suspension de fluide vers la région d'engagement au moins au cours du processus de polissage.

3. Appareil selon la revendication 1 ou 2, dans lequel un outil de rainurage (22, 23), par exemple un disque formateur de rainures (22), est monté pour s'engager sur la rainure dans le disque de polissage par déplacement soit de l'outil de rainurage vers le disque, soit du disque vers l'outil et un moyen pour faire tourner mutuellement à la fois le disque et l'outil de façon à former ou à reformer la rainure dans la surface du disque.

4. Appareil selon la revendication 3, dans lequel l'outil de rainurage est un disque (32) monté à l'arrière du porte-tranche pour tourner avec celui-ci et l'étape de formation est effectuée en déplaçant le disque rainuré (16) en engagement avec l'outil de rainurage et en les faisant tourner tous deux de manière à former ou à reformer la rainure dans le disque.

5. Appareil selon l'une quelconque des revendications 1 à 4, dans lequel le disque de polissage a une profondeur axiale importante et deux rainures parallèles ou plus sont formées autour de celui-ci de telle sorte que, lorsqu'une rainure est usée et nécessite un reformage, le disque puisse être soumis à une rotation pas à pas de manière à utiliser une autre des rainures afin de polir le bord de la tranche et le processus de déplacement d'une rainure à l'autre peut être continué jusqu'à ce que toutes les rainures aient été utilisées et nécessitent un reformage avant que le procédé soit arrêté et qu'un processus de reformage soit réalisé sur les rainures du disque de polissage.

6. Appareil selon l'une quelconque des revendications 1 à 5, comprenant un mandrin à vide pour recevoir et supporter la tranche, un moyen d'entraînement pour faire tourner le mandrin et, par suite, la tranche autour de son centre, un moyen pour monter un disque de polissage rainuré pour une rotation autour de son axe central de telle sorte que son sens de rotation soit l'inverse de celui de la rotation de la tranche dans la région dans laquelle ils entreront en contact, un moyen d'entraînement pour faire avancer et retirer le moyen de montage du disque de polissage afin de permettre au disque de polissage de venir en contact avec le bord de la tranche à des fins de polissage, et un moyen pour provoquer un ajustement relatif entre le disque de polissage et le moyen de montage afin de s'assurer que la rainure de la surface du disque de polissage s'aligne de manière précise avec le bord de la tranche.

7. Appareil selon l'une quelconque des revendications 1 à 6, dans lequel lesdits autres moyens d'entraînement sont produits par au moins un vérin pneumatique, dont la pression est régulée de telle sorte que la force sur les faces opposées de la tranche soit constante quel que soit le déplacement du vérin.

8. Procédé de meulage et de polissage de bord de tranches semi-conductrices qui sont transportées tour à tour dans un poste de meulage dans lequel le bord de la tranche est meulé, et la tranche est ensuite transférée à un magasin tampon tandis que la tranche suivante est transportée vers le poste de meulage et y est positionnée pour meulage, ledit procédé comprenant en outre les étapes de rotation de la tranche dans le magasin tampon et d'engagement de son bord avec un disque de polissage pour polir sa périphérie, tandis que la tranche suivante est en cours de meulage, et, après polissage, la tranche polie est retirée et la tranche suivante est transférée du poste de meulage au magasin tampon pour polissage afin de permettre à une autre tranche d'être positionnée dans le poste de meulage, l'étape de polissage étant effectuée par un mouvement basculant entre le disque de polissage et le bord de la tranche en faisant basculer soit le disque, soit la tranche autour d'un axe en coïncidence ou parallèlement avec une tangente qui coupe le premier contact entre la tranche et le disque de polissage.

9. Procédé selon la revendication 8, dans lequel les tranches en attente d'un meulage sont contenues dans un premier magasin et les tranches meulées et polies sont contenues dans un second magasin.

10. Procédé selon la revendication 9, dans lequel le premier et le second magasins sont différentes sections d'un seul dispositif de stockage.

11. Procédé selon l'une quelconque des revendications 8 à 10, dans lequel le magasin tampon comprend un poste de lavage, et comprenant en outre l'étape de lavage de la tranche meulée avant l'étape de polissage.

12. Procédé selon l'une quelconque des revendications 8 à 10, dans lequel la tranche est lavée après avoir été polie.

13. Procédé selon l'une quelconque des revendications 8 à 12, comprenant en outre l'étape de formation et de reformation d'une rainure dans le disque de polissage après qu'une ou plusieurs étapes de polissage ont été réalisées.

14. Procédé selon la revendication 13, dans lequel la formation et la reformation de la rainure dans le disque de polissage sont effectuées au moyen d'un disque formateur de rainures ayant un rebord périphérique en coupe transversale triangulaire définissant en coupe transversale deux bords tronconiques inclinés qui convergent vers un sommet et, après polissage d'une ou plusieurs tranches, un mouvement relatif est effectué entre le disque formateur de rainures et le disque de polissage, tandis que tous deux tournent autour de leurs axes respectifs, de manière à former ou à reformer le profil en coupe transversale de la rainure dans le disque de polissage afin qu'il soit prêt à polir les bords d'autres tranches.

15. Procédé selon l'une quelconque des revendications 8 à 14, comprenant par ailleurs l'étape de projection d'une suspension de fluide vers le point d'engagement entre le disque de polissage rainuré et la périphérie de la tranche au moins au cours de leur engagement de polissage mutuel.

16. Procédé selon l'une quelconque des revendications 8 à 15, dans lequel un outil de rainurage, par exemple un disque formateur de rainures, est situé à proximité du disque de polissage rainuré pour s'engager avec celui-ci afin de former et de reformer la rainure dans le disque selon les besoins.

17. Procédé selon l'une quelconque des revendications 8 à 16, dans lequel le disque de polissage est constitué d'un matériau synthétique et est amené en contact avec le bord rotatif de la tranche, ledit disque ayant été préalablement façonné autour de sa surface de polissage avec une rainure dont la section transversale est le complément du profilé de bord de la tranche, une suspension de polissage est délivrée à la zone de contact entre le disque de polissage et le bord de la tranche, et le disque de polissage est soumis à une rotation de telle sorte qu'un mouvement relatif existe entre le disque de polissage et ledit bord.
